(19) Europäisches Patentamt
European Patent Office
Office européen des brevets

(11) EP 4 266 071 A1

(12) EUROPEAN PATENT APPLICATION

(43) Date of publication:
25.10.2023 Bulletin 2023/43

(21) Application number: 22169164.5

(22) Date of filing: 21.04.2022

(51) International Patent Classification (IPC):
G01R 33/24 (2006.01)     G01R 33/44 (2006.01)
G01R 33/56 (2006.01)     G01R 33/561 (2006.01)

(52) Cooperative Patent Classification (CPC):
G01R 33/5608; G01R 33/246; G01R 33/443;
G01R 33/5613

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(71) Applicant: Koninklijke Philips N.V.
5656 AG Eindhoven (NL)

(72) Inventor: KATSCHER, Ulrich, Wolfgang
Eindhoven (NL)

(74) Representative: Philips Intellectual Property &
Standards
High Tech Campus 52
5656 AG Eindhoven (NL)

(54) **MR ELECTRIC PROPERTIES TOMOGRAPHY**

(57)     The invention relates to a method of MR imaging of an object (10) placed in an examination volume of an MR system (1). It is an object of the invention to enable an improved differentiation between abnormal/malignant tissue and tissue having a high water content in MR-EPT. The method of the invention comprises the following steps: generating MR signals by subjecting the object (10) to an imaging sequence comprising RF pulses and switched magnetic field gradients; acquiring the MR signals; reconstructing a magnitude MR image and a phase map from the MR signals for a given field of view within the object (10), which phase map is related to the spatial RF field distribution induced by the RF pulses within the field of view; deriving an electric conductivity map from the phase map, which electric conductivity map represents a measurement of the distribution of the electric conductivity within the field of view; deriving a further electric conductivity map from the magnitude MR image, which further electric conductivity map represents an estimation of the electric conductivity resulting from the distribution of water within the field of view; and identifying deviations of the two electric conductivity maps. Moreover, the invention relates to an MR system for carrying out this method as well as to a computer program to be run on an MR system.

Fig. 4

**Description**

FIELD OF THE INVENTION

The invention relates to the field of magnetic resonance (MR) imaging. It concerns a method of MR imaging of an object. The invention also relates to an MR system and to a computer program to be run on an MR system.

BACKGROUND OF THE INVENTION

Image-forming MR methods which utilize the interaction between magnetic fields and nuclear spins in order to form two-dimensional or three-dimensional images are widely used nowadays, notably in the field of medical diagnostics, because for imaging of soft tissue they are superior to other imaging methods in many respects, do not require ionizing radiation and are usually not invasive.

Electrical properties (EPs), also known as dielectric properties, including electrical conductivity are fundamental properties of materials. Conductivity characterizes the capability to transfer electrical current inside a medium. In biological tissues, EPs are determined by the fundamental biophysical properties of the tissue, such as water content, ion concentration, molecular composition, fraction of intracellular space, permeability of the cell membrane, cellular structure, etc. Electrical conductivity can potentially be used as a biomarker indicating the healthiness condition of tissue in clinical applications. Previous studies have shown that various diseases cause local changes of EPs relative to the healthy nearby tissue. Among various cancers, breast cancerous tissue has been shown with the most different EPs compared to normal breast tissue. Benign breast tissue shows significantly different conductivity compared to malignant breast carcinoma.

Magnetic resonance electric properties tomography (MR-EPT) is a technique using MR imaging to investigate the electric conductivity of tissue (see, e.g., Katscher et al., NMR Biomed., 2017, 30). The electric conductivity can be obtained from a simple and common imaging sequence (e.g. a so-called balanced fast field echo sequence - bFFE). The excitation of magnetic resonance is related to the spatial RF (magnetic) field distribution. The RF field distribution can be measured directly using conventional $B_1$ mapping techniques. The unknown electric conductivity can be calculated by post-processing of the RF field distribution in the framework of Maxwell's equations from an acquired phase map wherein the phase map is related to the spatial RF field distribution induced by the RF pulses in the object.

In terms of reliable diagnosis, it is of importance to take into account that high electric conductivity does not necessarily indicate abnormal tissue, and, vice versa, a highly abnormal state of tissue is not necessarily associated with a high electric conductivity. The electric conductivity is primarily determined by the water content of the examined tissue, not by the degree of tissue abnormality. Hence, it is an issue in conventional MR-EPT techniques that regions of high electric conductivity can be misinterpreted intuitively as pathology while the region actually only has a high water content and is completely healthy. Misdiagnoses can be the result.

SUMMARY OF THE INVENTION

From the foregoing it is readily appreciated that there is a need for an improved MR-EPT imaging method. It is consequently an object of the invention to enable an improved differentiation between abnormal/malignant tissue and tissue that only has a high water content in MR-EPT.

In accordance with the invention, a method of MR imaging of an object placed in an examination volume of an MR system is disclosed. The method comprises the steps of:

-    generating MR signals by subjecting the object to an imaging sequence comprising RF pulses and switched magnetic field gradients;
-    acquiring the MR signals;
-    reconstructing a magnitude MR image and a phase map from the MR signals for a given field of view within the object, which phase map is related to the spatial RF field distribution induced by the RF pulses within the field of view;
-    deriving an electric conductivity map from the phase map, which electric conductivity map represents a measurement of the distribution of the electric conductivity within the field of view;
-    deriving a further electric conductivity map from the magnitude MR image, which further electric conductivity map represents an estimation of the electric conductivity resulting from the distribution of water within the field of view; and
-    identifying deviations of the two electric conductivity maps.

The invention proposes, in other words, to use the estimated electric conductivity map associated with the water content to 'normalize' the conductivity maps actually measured by MR-EPT. The resulting normalized tissue conductivity can be directly interpreted as degree of tissue abnormality which is indicated by deviations of the two electric conductivity maps. The implementation of the invention is to reconstruct the 'measured' electric conductivity from the phase image and estimate the electric conductivity associated with the water content of the tissue from the magnitude MR image (indicating i.a. the proton density and, thus, the water content). This allows a direct voxel-by-voxel calculation of a normalized electric conductivity from a single MR scan, e.g. by subtracting the two electric conductivity maps. Tissue abnormalities can be identified by non-zero (positive or negative) voxel values in the thus normalized electric conductivity map.

In an embodiment, the imaging sequence is a steady state gradient echo sequence, preferably a balanced fast field echo (bFFE) sequence. In general, steady state imaging sequences are based on a gradient echo imaging sequence with a short repetition time TR. Steady state sequences include transverse coherences from overlapping multi-order spin echoes and stimulated echoes. This is usually accomplished by refocusing the phase-encoding gradient in each repetition interval in order to keep the phase integral (or gradient moment) constant. Fully balanced steady state imaging sequences achieve a phase of zero by refocusing all imaging gradients. The phase map is suitable for MR-EPT if it only relates to $B_1$, and is not influenced by inhomogeneity of the main magnetic field $B_0$. Conventionally, any unwanted influence of $B_0$ inhomogeneity is avoided by using spin echo based imaging sequences. However, $B_0$ inhomogeneity influences on the phase map are negligible in steady state acquisitions, because the phase remains almost unchanged for off-resonances within the pass band of the imaging sequence (frequency range corresponding to 1/TR). The $B_1$-related phase map can directly be derived for each position in a reconstructed complex MR image from the real and imaginary parts of the respective voxel value.

In another embodiment, the deriving of the further electric conductivity map involves a rescaling of the magnitude image. The invention thus exploits that the relation between the voxel values of the magnitude MR image and the electric conductivity at the respective position can be parametrized using a simple empirical rescaling function. The rescaling can then be based on a calibration, which calibration involves fitting an empirical rescaling function to a measured electric conductivity map for a different field of view, i.e. in healthy tissue where no deviations between the electric conductivity measured by MR-EPT and the electric conductivity resulting from the distribution of water are expected.

In yet another embodiment, the method further comprises the step of acquiring a $B_1$ magnitude map representing the distribution of the magnitude of the RF field induced by the RF pulses within the field of view, wherein the electric conductivity map is derived from the phase map and the $B_1$ magnitude map. For the exact calculation of the electric conductivity according to Maxwell's equations, both $B_1$ magnitude and phase are required. Hence, it can be advantageous to rely not only on the phase map but to perform also an additional $B_1$ mapping step to have the distribution of the $B_1$ magnitude available as well. However, a sufficiently good approximation of the conductivity is in most cases obtained by using only the phase map and considering the $B_1$ magnitude to be constant. This approximation may be used in practice because it saves the time-consuming measurement of the $B_1$ magnitude map.

The method of the invention does not necessarily have to be performed in direct combination with the acquisition of the MR signals. It can also be carried out independently thereof outside of an MR system as a pure post-processing step of the acquired and reconstructed image data. In this respect, the invention relates as a further aspect to a computer-implemented method comprising the following steps:

- providing a magnitude MR image and a phase map for a given field of view;
- deriving an electric conductivity map from the phase map, which electric conductivity map represents a measurement of the distribution of the electric conductivity within the field of view;
- deriving a further electric conductivity map from the magnitude image, which further electric conductivity map represents an estimation of the electric conductivity resulting from the distribution of water within the field of view; and
- identifying deviations of the two electric conductivity maps.

The methods of the invention described thus far can be carried out by means of an MR system including at least one main magnet coil for generating a uniform static magnetic field within an examination volume, a number of gradient coils for generating switched magnetic field gradients in different spatial directions within the examination volume, at least one RF coil for generating RF pulses within the examination volume and/or for receiving MR signals from an object positioned in the examination volume, a control unit for controlling the temporal succession of RF pulses and switched magnetic field gradients, and a reconstruction unit. The method of the invention can be implemented, for example, by a corresponding programming of the reconstruction unit and/or the control unit of the MR system.

The method of the invention can be advantageously carried out in most MR systems in clinical use at present. To this end it is merely necessary to utilize a computer program by which the MR system is controlled such that it performs the above-explained method steps of the invention. The computer program may be present either on a data carrier or be present in a data network so as to be downloaded for installation in the control unit of the MR system. The computer program can also be executable independently of an MR system, e.g. on a commercially available personal computer.

BRIEF DESCRIPTION OF THE DRAWINGS

The enclosed drawings disclose preferred embodiments of the present invention. It should be understood, however, that the drawings are designed for the purpose of illustration only and not as a definition of the limits of the invention. In the drawings:

Fig. 1 shows an MR system for carrying out the method of the invention;
Fig. 2 illustrates the method of the invention as a flow chart;
Fig. 3 shows a diagram illustrating the calibration for rescaling of the magnitude MR image according to the invention; and
Fig. 4 shows schematic conductivity maps illustrating the normalization approach of the invention.

DETAILED DESCRIPTION OF EMBODIMENTS

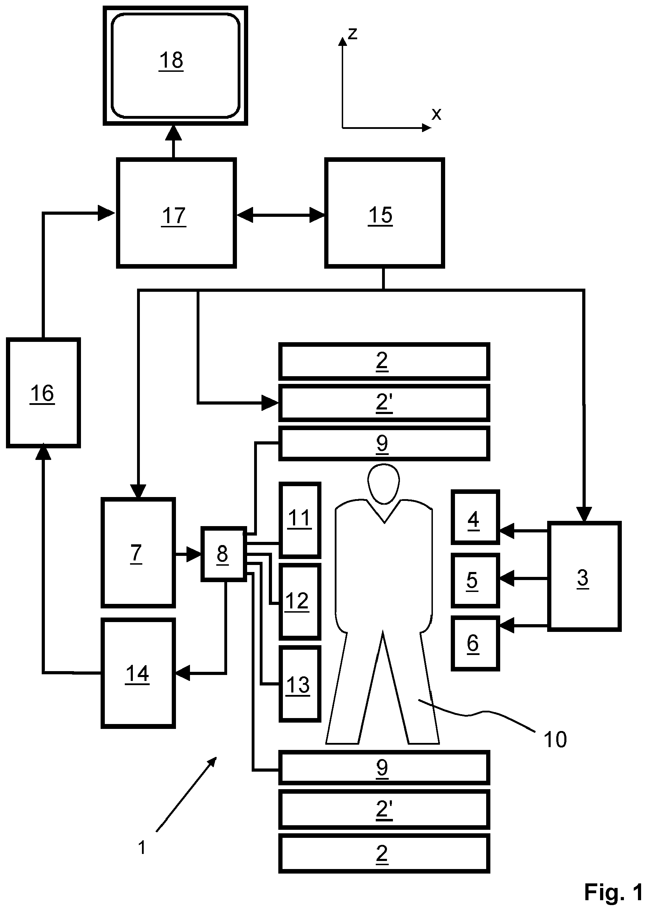

With reference to Fig. 1, an MR system 1 is shown. The device comprises superconducting or resistive main magnet coils 2, 2' such that a substantially uniform, temporally constant main magnetic field is created along a z-axis through an examination volume.

A magnetic resonance generation and manipulation system applies a series of RF pulses and switched magnetic field gradients to invert or excite nuclear magnetic spins, induce magnetic resonance, refocus magnetic resonance, manipulate magnetic resonance, spatially and otherwise encode the magnetic resonance, saturate spins, and the like to perform MR imaging.

More specifically, a gradient pulse amplifier 3 applies current pulses to selected ones of whole-body gradient coils 4, 5 and 6 along x, y and z-axes of the examination volume. A digital RF transmitter 7 transmits RF pulses or pulse packets, via a send-/receive switch 8, to a whole-body volume RF coil 9 to transmit RF pulses into the examination volume. A typical MR imaging sequence is composed of a packet of RF pulse segments of short duration which taken together with each other and any applied magnetic field gradients achieve a selected manipulation of nuclear magnetic resonance. The RF pulses are used to saturate, excite resonance, invert magnetization, refocus resonance, or manipulate resonance and select a portion of a body 10 positioned in the examination volume. The MR signals are also picked up by the whole-body volume RF coil 9.

For generation of MR images of limited regions of the body 10, a set of local array RF coils 11, 12, 13 are placed contiguous to the region selected for imaging. The array coils 11, 12, 13 can be used to receive MR signals induced by body-coil RF transmissions.

The resultant MR signals are picked up by the whole body volume RF coil 9 and/or by the array RF coils 11, 12, 13 and demodulated by a receiver 14 preferably including a preamplifier (not shown). The receiver 14 is connected to the RF coils 9, 11, 12 and 13 via send-/receive switch 8.

A host computer 15 controls the gradient pulse amplifier 3 and the transmitter 7 to generate any of a plurality of MR imaging sequences, such as a balanced fast field echo (bFFE) imaging sequence or the like. For the selected sequence, the receiver 14 receives a single or a plurality of MR data lines in rapid succession following each RF excitation pulse. A data acquisition system 16 performs analog-to-digital conversion of the received signals and converts each MR data line to a digital format suitable for further processing. In modern MR systems the data acquisition system 16 is a separate computer which is specialized in acquisition of raw image data.

Ultimately, the digital raw image data is reconstructed into an image representation by a reconstruction processor 17 which applies a Fourier transform or other appropriate reconstruction algorithms, such as SENSE, SMASH, or GRAPPA. The MR image may represent a planar slice through the patient, an array of parallel planar slices, a three-dimensional volume, or the like. The image is then stored in an image memory where it may be accessed for converting slices, projections, or other portions of the image representation into appropriate format for visualization, for example via a video monitor 18 which provides a man-readable display of the resultant MR image.

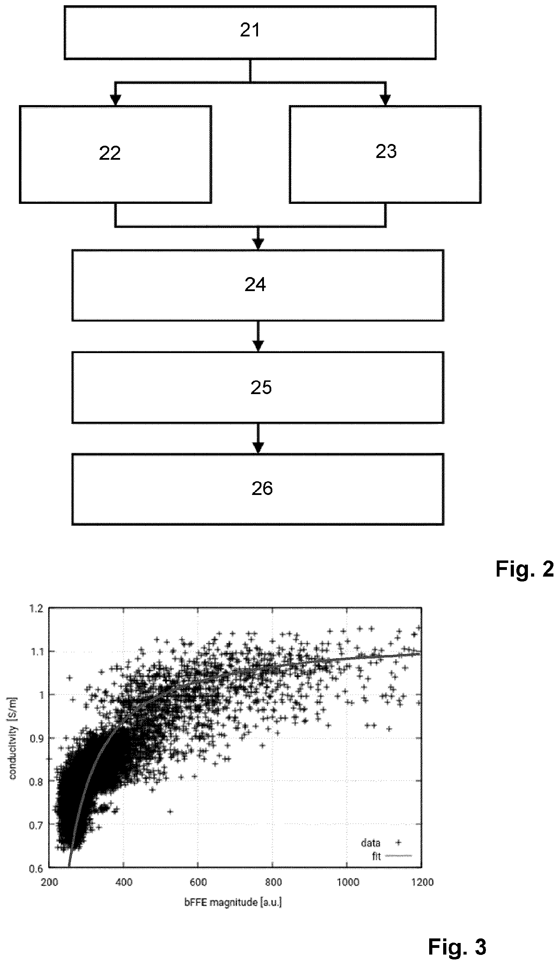

With continuing reference to Fig. 1 and with further reference to Figs. 2-4 an embodiment of the method of the invention is explained in the following.

In step 21 (Fig. 2), the body 10 is subjected to a steady state bFFE imaging sequence. The generated echo signals are acquired and reconstructed into a complex MR image of a given field of view (2D or 3D). A magnitude MR image is derived from the complex MR image, and a $B_1$-related phase map is directly derived for each position in the reconstructed MR image from the real and imaginary parts of the respective complex image value $S_c$:

$$\varphi(\mathbf{r}) = \operatorname{atan2}\left(\operatorname{Im}\left(S_c\right),\operatorname{Re}\left(S_c\right)\right)$$

This phase information is used in step 22 according to the conventional phase-based EPT method to compute an electric conductivity map representing a measurement of the distribution of the electric conductivity $\sigma_{meas}$ within the field of view. In step 23, a different field of view, i.e. a 'healthy' area within the imaged anatomy is identified where no electric conductivity abnormalities are expected. The different field of view may be, e.g., a different image slice or a sub-region within the given field of view for which the magnitude image and the electric conductivity maps have already been derived in steps 21 and 22. To estimate the electric conductivity resulting from the distribution of water within the field of view a rescaling function is determined in step 24. On an empirical basis, the relation between the bFFE magnitude MR image $S_m$ and the estimated electric conductivity $\sigma_{est}$ of healthy tissue at the respective position can be parametrized by, e.g.

$$\sigma_{est} = \frac{a}{1+\frac{b}{S_m - c}}$$

Both, $\sigma_{est}$ and $S_m$, are related to the water content. An example of this relationship is shown in the diagram of Fig. 3 (scatter plot of electric conductivity reconstructed from the bFFE phase versus the bFFE magnitude). The parameters $a$, $b$, and $c$ depend on system settings and have to be adjusted for each MR imaging scan individually (with $a$ adjusting the conductivity scaling, $b$ adjusting the curvature of the function, and $c$ adjusting the range of the bFFE magnitude MR image). For calibration of the rescaling function, a least squares fit is performed to find the best match between the magnitude MR image and the measured electric conductivity in the identified healthy area. The solid line in Fig. 3 shows the fit based on the above equation, visualizing the relationship between $S_m$ and $\sigma_{meas}$. For the depicted in vivo example, optimal parameters adjusted were $a = 1.14$, $b = 40.0$, $c = 211$. Once the optimum parameters $a$, $b$, and $c$ are found in this way, the magnitude MR image for the full given field of view (also including a suspicious, potentially abnormal tissue region) is rescaled using the rescaling function in step 25 to obtain the estimated electric conductivity $\sigma_{est}$ resulting from the distribution of water within the given field of view. Finally, in step 26, the estimated electric conductivity $\sigma_{est}$ is subtracted from the measured conductivity $\sigma_{meas}$ throughout the full given field of view:

$$\sigma_{norm} = \sigma_{meas} - \sigma_{est} = \sigma_{meas} - \frac{a}{1 + \frac{b}{S_m - c}}$$

yielding the normalized conductivity $\sigma_{norm}$. $\sigma_{norm}$ can be negative or positive and indicates deviations of the measured conductivity $\sigma_{meas}$ from the estimated conductivity $\sigma_{est}$, thus indicating abnormal areas. In the (supposed to be healthy) area which has been used to adjust the constants $a$, $b$, $c$ in step 24, the resulting $\sigma_{norm}$ thus should be approximately zero.

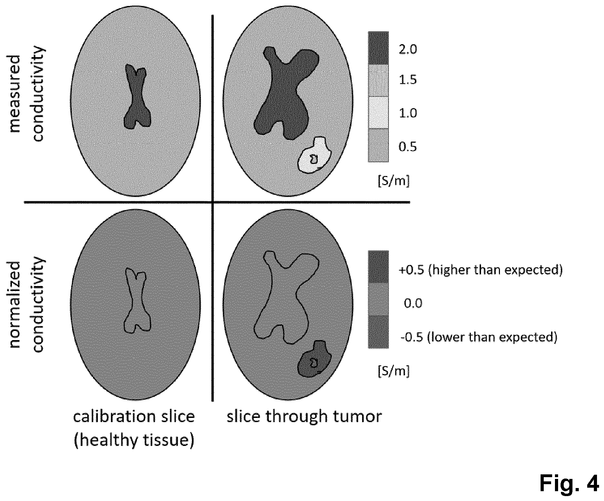

This is schematically illustrated in Fig. 4 showing an example of a brain tumor. The given field of view is referred to as 'slice through tumor' while the different field of view, i.e. the healthy area used for calibration of the rescaling function is referred to as 'calibration slice'. The upper row shows the EPT-reconstructed electric conductivity maps $\sigma_{meas}$ for the two slices (left: containing only healthy tissue, right: including tumor). Although cerebral spinal fluid (CSF) shows highest conductivity in the centre of the given field of view, this is not the pathologic area within the field of view. The lower row shows the normalized electric conductivity $\sigma_{norm}$ for the same two slices. Since the normalization is based on the 'healthy' calibration slice (left), the normalized conductivity $\sigma_{norm}$ of this slice is zero. The normalization in the tumor slice shows zero in the healthy areas and non-zero in the tumor core where the conductivity is lower than normal and in the tumor-surrounding edema where the conductivity is higher than normal.

**Claims**

1. Method of MR imaging of an object (10) placed in an examination volume of an MR system (1), the method comprising the steps of:

   - generating MR signals by subjecting the object (10) to an imaging sequence comprising RF pulses and switched magnetic field gradients;
   - acquiring the MR signals;
   - reconstructing a magnitude MR image and a phase map from the MR signals for a given field of view within the object (10), which phase map is related to the spatial RF field distribution induced by the RF pulses within the field of view;
   - deriving an electric conductivity map from the phase map, which electric conductivity map represents a measurement of the distribution of the electric conductivity within the field of view;
   - deriving a further electric conductivity map from the magnitude MR image, which further electric conductivity map represents an estimation of the electric conductivity resulting from the distribution of water within the field of view; and
   - identifying deviations of the two electric conductivity maps.

2. Method of claim 1, wherein the imaging sequence is a steady state gradient echo sequence, preferably a balanced fast field echo sequence.

3. Method of claim 1 or 2, wherein the deriving of the further electric conductivity map involves a rescaling of the magnitude image.

4. Method of claim 3, wherein the rescaling is based on a calibration, which calibration involves fitting an empirical rescaling function to a measured electric conductivity map for a different field of view, in which no deviations between the measured electric conductivity and the electric conductivity resulting from the distribution of water are expected.

5. Method of any one of claims 1-4, wherein the identifying of deviations of the two electric conductivity maps involves subtracting the two electric conductivity maps.

6. Method of any one of claims 1-5, further comprising the step of acquiring a $B_1$ magnitude map representing the distribution of the magnitude of the RF field induced by the RF pulses within the field of view, wherein the electric conductivity map is derived from the phase map and the $B_1$ magnitude map.

7. Computer-implemented method comprising the steps of:

- providing a magnitude MR image and a phase map for a given field of view;
- deriving an electric conductivity map from the phase map, which electric conductivity map represents a measurement of the distribution of the electric conductivity within the field of view;
- deriving a further electric conductivity map from the magnitude image, which further electric conductivity map represents an estimation of the electric conductivity resulting from the distribution of water within the field of view; and
- identifying deviations of the two electric conductivity maps.

8. MR system including at least one main magnet coil (2) for generating a uniform, static magnetic field within an examination volume, a number of gradient coils (4, 5, 6) for generating switched magnetic field gradients in different spatial directions within the examination volume, at least one RF coil (9) for generating RF pulses within the examination volume and/or for receiving MR signals from an object (10) positioned in the examination volume, a control unit (15) for controlling the temporal succession of RF pulses and switched magnetic field gradients, and a reconstruction unit (17), wherein the MR system (1) is arranged to perform the method of any one of claims 1-7.

9. Computer program comprising instructions which, when the program is executed by a computer, preferably by a reconstruction unit (17) of an MR system (1), cause the computer to carry out the method of any one of claims 1-7.

**Fig. 1**

**Fig. 2**

**Fig. 3**

Fig. 4

Europäisches
Patentamt

European
Patent Office

Office européen
des brevets

# EUROPEAN SEARCH REPORT

Application Number

EP 22 16 9164

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | STEFANO MANDIJA ET AL: "In-vivo validation of water content Electrical Properties Tomography reconstructions in white matter using independent MR-EPT measurements", PROCEEDINGS OF THE INTERNATIONAL SOCIETY FOR MAGNETIC RESONANCE IN MEDICINE, 26TH ANNUAL MEETING AND EXHIBITION, PARIS, FRANCE, 16-21 JUNE 2018, vol. 26, 5096, 1 June 2018 (2018-06-01), XP040704304, | 7-9 | INV. G01R33/24 G01R33/44 G01R33/56 ADD. G01R33/561 |
| A | * page 1; figures 1, 3 * ----- | 1-6 | |

TECHNICAL FIELDS SEARCHED (IPC)

G01R

The present search report has been drawn up for all claims

| Place of search | Date of completion of the search | Examiner |
|---|---|---|
| Munich | 4 October 2022 | Raguin, Guy |

EPO FORM 1503 03.82 (P04C01)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

• **KATSCHER et al.** *NMR Biomed.,* 2017, vol. 30